# EUROPÄISCHE PATENTANMELDUNG

(11) **EP 2 876 586 A1**
(43) Veröffentlichungstag der Anmeldung: **27.05.2015**
(21) Anmeldenummer: 13194503.2
(22) Anmeldetag: 26.11.2013
(51) Int. Cl.: G06Q 10/04

(54) **Verfahren und System zum Entwerfen von Flugzeugen**

(71) Anmelder: Deutsche Lufthansa AG, 50679 Köln (DE)
(72) Erfinder: Echtmeyer, Karl, 65719 Hofheim (DE); Coenen, Werner, 60488 Frankfurt (DE)
(74) Vertreter: Glawe, Delfs, Moll

(57) **Zusammenfassung**

Die Erfindung betrifft ein Verfahren (10) und ein System (1) zum Entwerfen von Flugzeugen, insbesondere von Passagier- und Frachtflugzeugen im zivilen Bereich. Das erfindungsgemäße Verfahren umfasst die Schritte:
a. Festlegen eines initialen Anforderungskatalogs für wenigstens einen Flugzeugentwurf (Schritt 11);
b. Durchführen einer Optimierung des wenigstens einen Flugentwurfs auf Basis des Anforderungskatalogs hinsichtlich der zu erwartenden Betriebskosten (Schritt (13);
c. Simulation eines vorgegebenen Gesamtflugnetzes mit dem wenigstens einen Flugzeugentwurf und Ermittlung der Gesamtflugnetzeffizienz (Schritt 18);
d. Überprüfung, ob die ermittelte Gesamtflugnetzeffizienz ein Optimum darstellt (Schritt 19); wenn nicht:
e. Anpassung des Anforderungskatalogs (Schritte 19 und 12) und Iteration ab Schritt (b).

Das erfindungsgemäße System (1) ist zur Durchführung dieses Verfahrens (10) ausgebildet.

## Beschreibung

Die Erfindung betrifft ein Verfahren und ein System zum Entwerfen von Flugzeugen, insbesondere von Passagier- und Frachtflugzeugen im zivilen Bereich.

Die Konstruktion und der Bau von neuen Flugzeugen sind sehr aufwendig und äußerst kostenintensiv. Bevor ein Flugzeughersteller ein neues Flugzeugmodell plant, versucht er daher vor Beginn der eigentlichen Konstruktions- und Entwicklungsphase zu ermitteln, welche insbesondere technischen, operationellen und wirtschaftlichen Eigenschaften das vorgesehene neue Flugzeugmodell aufweisen sollte, um gut am Markt angenommen zu werden und so die hohen Entwicklungskosten zu rechtfertigen.

Bislang ist es hierzu üblich, Vertreter von Fluggesellschaften - und damit Vertreter von potenziellen Kunden - zu so genannten "Customer-Focus-Group"- oder "Airline-Advisory-Board"-Veranstaltungen einzuladen. Bei entsprechenden Veranstaltungen werden die Vertreter der Fluggesellschaften nach ihren Wünschen hinsichtlich der Auslegungsparameter eines neuen Flugzeugmodells befragt. Zu den abgefragten Auslegungsparametern zählen beispielsweise die erwünschte Nutzlastmasse (betrifft im Wesentlichen die Größe des Rumpfes bezüglich der beispielsweise zu befördernden maximalen Anzahl der Passagiere plus Fracht), die Reichweitenanforderung, Start- und Landeanforderungen, die gewünschte Reiseflughöhe sowie gegebenenfalls weitere Auslegungsparameter wie beispielsweise die gewünschte Reisefluggeschwindigkeit, Maximalwerte für Spannweite, Rumpflänge und/oder Flächenpressung pro Fahrwerksrad vorgegeben sein.

Die von den Vertretern der Fluggesellschaften abgegebenen Einschätzungen hinsichtlich der Auslegungsparameter werden anschließend zusammengefasst und statistisch ausgewertet. Anschließend wird der Flugzeughersteller auf Basis der statistischen Auswertung und nach weiteren Expertenbefragungen bestimmte Auslegungsparameter als Auslegungspunkt für das neue Flugzeugmodell festlegen.

Auf Basis des so ermittelten Auslegungspunkts wird dann ein Syntheseverfahren angewendet, welches eine iterative Optimierung eines, dem Auslegungspunkt genügenden Flugzeugentwurfs hinsichtlich der Kosten ermöglicht. Das entsprechende Syntheseverfahren nach dem bisherigen Stand der Technik ist u. a. beschrieben in "Synthesis of Subsonic Airplane Design: An introduction to the preliminary design of subsonic general aviation and transport aircraft, with emphasis on layout, aerodynamic design, propulsion and performance" von Egbert Torenbeek, erschienen 1982 bei Delft University Press, 9. Reprint 1999 sowie in "Advanced Aircraft Design: Conceptual Design, Technology and Optimization of Subsonic Civil Airplanes" von Egbert Torenbeek, erschienen 2013 bei John Wiley & Sons.

Bei dem Syntheseverfahren werden zunächst Antriebs-, Tragflächen- und Leitwerksdimensionierung, eine daraus zusammen mit den Parametern des Auslegungspunkts resultierende Massenabschätzung sowie eine vorläufige Abschätzung der Flugleistungen derart iterativ optimiert, dass das Höchstabfluggewicht konvertiert und die Reichweiten-, Start- und Landeanforderungen gemäß Auslegungspunkt erfüllt sind. Anschließend wird für einen entsprechend optimierten Entwurf eine Kostenabschätzung vorgenommen, wobei insbesondere die späteren Betriebskosten abgeschätzt werden. Es wird dann überprüft, ob es sich bei dem Entwurf um den kostenoptimalen Entwurf handelt. Ist dies nicht der Fall, wird die oben beschriebene Iteration mit anderen Ausgangsgrößen (beispielsweise der Antriebsdimensionierung) so häufig wiederholt, bis ein Kostenoptimum erreicht wird.

Das beschriebene Verfahren führt zu einem hinsichtlich des vorgegebenen Auslegungspunkts optimierten Flugzeugentwurf. Allerdings ist bei den aus dem Stand der Technik bekannten Verfahren nicht gewährleistet, dass auch der Auslegungspunkt, auf den hin der Flugzeugentwurf optimiert wird, optimal gewählt wird. So wird im Stand der Technik der letztendliche Auslegungspunkt auf Basis von Kundenbefragungen sowie subjektiven Expertenmeinungen festgelegt, was unbestritten das Risiko birgt, einen "falschen Auslegungspunkt" zu wählen. In der Folge kann ein Flugzeug "am Markt vorbei" dimensioniert werden und findet dann, wenn überhaupt, nur wenig Abnehmer. Die Konsequenzen können aufgrund der hohen Entwicklungskosten für den Flugzeughersteller fatal sein.

Der Erfindung liegt die Aufgabe zugrunde, ein verbessertes Verfahren und System zum Entwerfen von Flugzeugen zu schaffen, welches die Nachteile aus dem Stand der Technik nicht mehr oder nur noch in vermindertem Maße aufweist.

Diese Aufgabe wird gelöst durch das Verfahren gemäß dem Hauptanspruch sowie durch das System gemäß dem unabhängigen Anspruch 10. Vorteilhafte Weiterbildungen sind Gegenstand der abhängigen Ansprüche.

Demnach betrifft die Erfindung ein Verfahren zum Entwerfen von Flugzeugen, umfassend die Schritte:
a.Festlegen eines initialen Anforderungskatalogs für wenigstens einen Flugzeugentwurf;
b.Durchführen einer Optimierung des wenigstens einen Flugzeugentwurfs auf Basis des Anforderungskatalogs hinsichtlich der zu erwartenden Betriebskosten;
c.Simulation eines vorgegebenen Gesamtflugnetzes mit dem wenigstens einen Flugzeugentwurf und Ermittlung der Gesamtflugnetzeffizienz;
d.Überprüfung, ob die ermittelte Gesamtflugnetzeffizienz ein Optimum darstellt; wenn nicht:
e.Anpassung des Anforderungskatalogs und Iteration ab Schritt (b).

Die Erfindung betrifft weiterhin ein System umfassend:
- einen Anforderungskatalogspeicher zum Speichern eines Anforderungskatalogs für wenigstens einen Flugzeugentwurf;
- ein Synthesemodul zur Ermittlung von hinsichtlich der Kosten optimierten Flugzeugentwürfen auf Basis des Anforderungskatalogs aus dem Anforderungskatalogspeicher;
- ein Simulationsmodul zur Durchführung einer Simulation eines Gesamtflugnetzes mit den vom Synthesemodul (3) ermittelten Flugzeugentwürfen und zur Ermittlung der Gesamtflugnetzeffizienz; und
- ein Optimierungsmodul zur Überprüfung, ob die vom Simulationsmodul ermittelte Gesamtflugnetzeffizienz ein Optimum ist, und, sofern kein Optimum der Gesamtflugnetzeffizienz vorliegt, zur Veränderung des Anforderungskatalogs im Anforderungskatalogspeicher.

Das erfindungsgemäße Verfahren zum Entwerfen von Flugzeugen zeichnet sich dadurch aus, dass nicht nur ein Flugzeugentwurf auf einen bestimmten, vorgegebenen Anforderungskatalog hin optimiert wird, sondern dass zusätzlich auch der Anforderungskatalog derart optimiert wird, dass ein letztendlicher Flugzeugentwurf möglichst optimal auf ein vorgegebenes Gesamtflugnetz abgestimmt ist. Anders als noch im Stand der Technik wird also nicht nur ein einzelner Flugzeugentwurf auf Basis eines vorgegebenen Auslegungspunktes hinsichtlich der Kosten optimiert, sondern es wird vielmehr sichergestellt, dass der Auslegungspunkt für einen Flugzeugentwurf hinsichtlich eines vorgegebenen Gesamtflugnetzes optimiert ist.

Bevor die Erfindung und deren Vorteile weiter beschrieben werden, werden zunächst einige in Zusammenhang mit der Erfindung verwendete Begriffe näher erläutert.

Im "Anforderungskatalog" sind einzelne technische Anforderungen betreffend den wenigstens einen Flugzeugentwurf zusammengefasst. Diese Anforderungen können bspw. die Nutzlastmasse, die Reichweite sowie Start- und Landeanforderungen umfassen, bspw. für hoch gelegene Flughäfen in heißen Regionen (Hot- & High-Airports) oder besonders kurze Start- und Landebahnen. Auch können minimale Reiseflughöhe, minimale Reisefluggeschwindigkeit und/oder Maximalwerte für Spannweite, Rumpflänge und/oder Flächenpressung pro Fahrwerksrad vorgegeben sein. Alternativ oder zusätzlich zur minimalen Nutzlastmasse können auch Anforderungen hinsichtlich der Anzahl der Passagiersitzplätze vorgesehen sein.

Der Anforderungskatalog kann die technischen Anforderungen für einen einzelnen Flugzeugentwurf umfassen. Es ist aber auch möglich, dass der Anforderungskatalog entsprechende Anforderungen für mehrere verschiedene Flugzeugentwürfe umfasst. So kann bspw. ein Anforderungskatalog einerseits Anforderungen für ein Kurzstreckenflugzeug, andererseits Anforderungen für ein Langstreckenflugzeug enthalten. Im Anforderungskatalog können auch gewisse Verknüpfungen zwischen den Anforderungen für mehrere verschiedene Flugzeugentwürfe vorgegeben sein. So ist bspw. möglich festzulegen, dass zwei Flugzeugentwürfe identische Tragflächen aufweisen sollen, um die Entwicklungskosten für beide Flugzeugentwürfe insgesamt zu reduzieren.

Bei einem "Gesamtflugnetz" handelt es sich um die Sammlung aller Flugstrecken einer oder mehrerer Fluggesellschaften, die von diesen Fluggesellschaften bedient werden oder bedient werden sollen. Das Gesamtflugnetz ist also nicht nur auf diejenigen Flugstrecken beschränkt, die nach Expertenmeinung durch einen neuen Flugzeugentwurf bedienbar sein sollten. Es ist auch möglich, dass das Gesamtflugnetz, welches dem erfindungsgemäßen Verfahren bzw. System zugrunde gelegt wird, lediglich ein Teilnetz eines tatsächlich vorhandenen Flugnetzes darstellt. Bspw. können, um die Simulation des Gesamtflugnetzes zu vereinfachen, einzelne Strecken, für die ein bereits vorhandener Flugzeugtyp speziell entwickelt wurde (z. B. extreme Langstrecke), von dem simulierten Gesamtflugnetz ausgenommen werden. Auch in diesem Fall ist das Gesamtflugnetz jedoch weiterhin nicht nur auf diejenigen Strecken beschränkt, die nach Expertenmeinung durch einen neuen Flugzeugentwurf bedienbar sein sollten.

Für die Simulation des Gesamtflugnetzes sind für jede einzelne Flugstrecke neben Informationen über die Länge der jeweiligen Flugstrecke vorzugsweise auch Informationen über die Start- und Landebedingungen an den einzelnen Flughäfen der jeweiligen Flugstrecke verfügbar. Für die einzelnen Flughäfen im Gesamtflugnetz können darüber hinaus noch beispielsweise Maximalwerte für Spannweite, Rumpflänge und/oder Flächenpressung eines Fahrwerksrades vorgegeben sein. Des Weiteren können noch Informationen über das Nutzlastaufkommen auf einer Flugstrecke und/oder Informationen über die Anzahl der Zeitfenster, an denen eine bestimmte Fluggesellschaft an einem Flughafen starten und landen darf (Flughafenslots), verfügbar sein. Alternativ oder zusätzlich zum Nutzlastaufkommen kann auch das Passagieraufkommen auf einer Flugstrecke verfügbar sein.

Bei dem der Simulation des erfindungsgemäßen Verfahrens zugrunde gelegten Gesamtflugnetz kann es sich um ein tatsächliches Gesamtflugnetz eines oder mehrerer Fluggesellschaften handeln. Es ist aber auch möglich, der Simulation ein theoretisches Gesamtflugnetz zugrunde zu legen. So ist es bspw. möglich, ausgehend von einem tatsächlichen Gesamtflugnetz ein zukünftiges Gesamtflugnetz zu projizieren, welches bspw. das erwartete oder geplante Gesamtflugnetz in naher Zukunft oder in 10 oder 20 Jahren darstellt.

Bei dem erfindungsgemäßen Verfahren wird zunächst ein initialer Anforderungskatalog für wenigstens einen neuen Flugzeugentwurf festgelegt. Dieser initiale Anforderungskatalog kann die technischen Anforderungen für lediglich einen Flugzeugentwurf enthalten. Es ist aber auch möglich, dass der initiale Anforderungskatalog technische Anforderungen für mehrere Flugzeugentwürfe enthält, bspw. ein oder mehrere Kurz- und ein oder mehrere Langstreckenflugzeuge.

Anschließend wird für jeden Flugzeugentwurf, für den technische Anforderungen im Anforderungskatalog enthalten sind, einzeln eine Optimierung des jeweiligen Flugzeugentwurfes durchgeführt. Die Optimierung erfolgt dabei in erster Linie hinsichtlich der Betriebskosten eines Flugzeugentwurfes, wobei sich die Betriebskosten als Funktionen von technischen Größen bzw. der Konfiguration des Flugzeugentwurfes berechnen lassen. So lassen sich bspw. der Treibstoffverbrauch und die damit verbunden Kosten aus technischen Parametern wie u. a. dem Schub-Masse-Verhältnis und/oder der Aerodynamikgüte des Flugzeugentwurfs berechnen, die Wartungskosten lassen sich in Abhängigkeit der Flugzeugmasse sowie der Anzahl der Triebwerke ermitteln, Flughafensteuern sind abhängig von der Flugzeugmasse, etc. Entsprechende Berechnungen der zu erwartenden Kosten bei einem Flugzeugentwurf sind aus dem Stand der Technik bekannt.

Zur Optimierung der Betriebskosten bzw. der zugrunde liegenden technischen Größen kann auf das aus dem Stand der Technik bereits bekannte Syntheseverfahren zurückgegriffen werden. Bei diesem Verfahren werden zunächst verschiedene Entwurfsgrößen, wie Antriebs-, Tragflächen- und Leitwerksdimensionierung, und daraus wenigstens teilweise resultierende Größen, wie Auftriebsverteilung des Flügels, Masse, Schwerpunkt, Widerstand und Flugleistungen, solange iteriert, bis das Höchstabfluggewicht konvergiert, bei Einhaltung der sonstigen Randbedingungen, wie Reichweiten-, Start- und Landeanforderung, etc. Anschließend wird eine Betriebskostenabschätzung durchgeführt und das vorbeschriebene iterative Verfahren solange wiederholt, bis ein Betriebskostenoptimum vorliegt. Die zu erwartenden Betriebskosten lassen sich auf Basis technischer Größen des Flugzeugentwurfs, wie oben erläutert, ermitteln.

Mit dem so optimierten Flugzeugentwurf bzw. den so optimierten Flugzeugentwürfen wird anschließend eine Simulation des Gesamtflugnetzes durchgeführt und die Gesamtflugnetzeffizienz ermittelt. Dabei wird für jede Flugstrecke des Gesamtflugnetzes eine Flugstreckeneffizienz ermittelt und die einzelnen Flugstreckeneffizienzen werden zur Gesamtflugnetzeffizienz summiert. Eine Flugstreckeneffizienz berechnet sich aus den für einen bestimmten Flugzeugentwurf auf einer bestimmten Flugstrecke zu erwartenden Einkünften abzüglich der Kosten für den Einsatz des Flugzeugentwurfs auf dieser Strecke. Flugstreckeneffizienzen für eine bestimmte Strecke können dabei nur für Flugzeugentwürfe ermittelt werden, welche die technischen Voraussetzungen für das Bedienen der Flugstrecke aufweisen, bspw. also über ausreichende Reichweite verfügen.

Bei der Simulation des Gesamtflugnetzes ist es möglich, dass zwei oder mehr Flugzeugentwürfe zum Einsatz auf einer bestimmten Flugstrecke geeignet sind. In diesem Fall wird vorzugsweise das Effizienzpotenzial eines jeden einzelnen Flugzeugentwurfs berechnet, welcher zum Einsatz auf der betreffenden Flugstrecke geeignet ist. Anschließend wird derjenige Flugzeugentwurf für diese Flugstrecke ausgewählt, dessen Effizienzwert zum höchsten Gesamtflugnetzeffizienzwert bei diesem Simulationsschritt beisteuert.

Es ist auch möglich, dass bei der Simulation einzelne Flugstrecken durch keinen der simulierten Flugzeugentwürfe bedient werden können. In diesem Fall kann die nichtbedienbare Strecke mit hohen Kosten belegt werden, was letztendlich zur Folge hat, dass die Gesamtflugnetzeffizienz einer Simulation, bei der einzelne Flugstrecken nicht bedient werden können, kein Optimum darstellen kann. Alternativ kann die Simulation des Gesamtflugnetzes auch abgebrochen werden, wenn eine Flugstrecke durch keinen der simulierten Flugzeugentwürfe bedient werden kann.

Bei der Simulation des Gesamtflugnetzes und der Ermittlung der Gesamtflugnetzeffizienz können Randbedingungen hinsichtlich der Auswahl der für die einzelnen Flugstrecken vorgesehenen Flugzeugentwürfe vorgegeben sein. So könnte bspw. vorgegeben sein, dass in dem Gesamtflugnetz oder einem bestimmten Teil des Gesamtflugnetzes nur eine maximale Anzahl an unterschiedlichen Flugzeugentwürfen zum Einsatz kommen soll und/oder dass jeder im Gesamtflugnetz eingesetzte Flugzeugentwurf auf einer Mindestanzahl an einzelnen Flugstrecken im Gesamtflugnetz einsetzbar sein soll oder muss. Die maximale Anzahl an unterschiedlichen Flugzeugentwürfen ist dabei vorzugsweise größer gleich zwei. Durch entsprechende Randbedingungen kann eine zu heterogene und daher nicht wirtschaftlich zu betreibende Flotte an unterschiedlichen Flugzeugentwürfen auf dem Gesamtflugnetz bereits in diesem Verfahrensschritt ausgeschlossen werden.

Die für die Berechnung einer Flugstreckeneffizienz erforderlichen zu erwartenden Einkünfte lassen sich bspw. aus dem Nutzlast- bzw. Passagieraufkommen auf einer Flugstrecke, den verfügbaren Flughafenslots sowie der Nutzlastmasse eines Flugzeuges, die auch in Anzahl von Sitzplätzen im Flugzeug umgerechnet werden kann, berechnen. Dabei können auch Erfahrungswerte, wie durchschnittliche Auslastung und jahreszeitliche Schwankungen in dem Passagier- bzw. Nutzlastaufkommen auf einer Flugsrecke berücksichtigt werden.

Handelt es sich bei der simulierten Flugstrecke um eine Passagierroute, ist es bevorzugt, wenn das Passagieraufkommen auf der Flugstrecke in Normaltarifpassagiere und Sondertarifpassagiere aufgeschlüsselt ist. Normaltarifpassagiere sind solche, die aus vorgegebenen äußeren Gründen (bspw. terminliche Unflexibilität) auf einer Flugstrecke reisen (müssen) und daher bereit sind, ein Flugticket auch zum Normalpreis zu erwerben. Zur Gruppe der Normaltarifpassagiere zählen insbesondere Geschäftsreisende. Bei den Sondertarifpassagieren handelt es sich um Passagiere, die nicht zwingend auf eine Flugstrecke angewiesen sind, sondern auch bereit sind, einen anderen Reiseweg (bspw. einen Umweg) zu ihrem Ziel zu wählen. Diese Art Passagiere nutzen eine dezidierte Flugstrecke eher, wenn sie günstige Flugtickets erwerben können. Solche preissensitiven Fluggäste reisen in der Regel oft aus privaten Gründen, wie bspw. Urlaub.

Ist das Passagieraufkommen in Normaltarifpassagiere und Sondertarifpassagiere aufgeschlüsselt, ist eine detailliertere Berechnung der zu erwartenden Einkünfte möglich. Insbesondere kann bei der Simulation so der Effekt abgebildet werden, dass bei einer anteiligen Veränderung des Passagieraufkommens von Normaltarifpassagieren zu Sondertarifpassagieren der durchschnittliche Ticketpreis der Tickets auf einer Flugstrecke und somit auch die Flugstreckeneffizienz sich verändern. Steigt beispielsweise das Passagieraufkommen an Normaltarifpassagieren und das Passagieraufkommen an Sondertarifpassagieren bleibt unverändert, dann sinkt der Anteil an Sondertarifpassagieren und somit der durchschnittliche Ticketpreis der Tickets auf einer Flugstrecke und somit auch die Flugstreckeneffizienz.

Selbstverständlich gilt Vergleichbares auch für sonstige Nutzlasten, die ebenfalls in eine Normaltarifnutzlast und eine Sondertarifnutzlast aufgeschlüsselt werden können. So kann es sich bei einer Normaltarifnutzlast um Nutzlasten handeln, die zu einem bestimmten Zeitpunkt schnell transportiert werden müssen, bspw. dringliche Ersatzteile, während Sondertarifnutzlasten ohne Weiteres trotz Zeitverlust auch durch andere Verkehrsmittel transportiert werden können, wenn die anderen Verkehrsmittel kostengünstiger sind.

Die für die Berechnung einer Flugstreckeneffizienz ebenfalls erforderlichen Kosten sind die Betriebskosten, die für ein bestimmtes Flugzeug auf der Flugstrecke zu erwarten sind. Diese zu erwartenden Betriebskosten lassen sich auf bekannte Weise über technische Größen des Flugzeugentwurfs ermitteln bzw. abschätzen. Die Betriebskosten können Treibstoffkosten, Wartungskosten, Personalkosten, Flughafengebühren etc. umfassen. Es ist auch möglich, dass die Kosten für eine Flugstrecke anteilig die Entwicklungskosten für ein neues Flugzeug umfassen. Die Entwicklungskosten können dabei bspw. anteilig auf diejenigen Flugstrecken umgelegt werden, auf denen das neu entwickelte Flugzeug gemäß der Simulation des Gesamtflugnetzes zum Einsatz kommen soll.

Wurde die Flugstreckeneffizienz für jede Flugstrecke des Gesamtflugnetzes berechnet und zur Gesamtflugnetzeffizienz aufsummiert, wird anschließend überprüft, ob es sich bei der mithilfe der Simulation ermittelten Gesamtflugnetzeffizienz um ein Optimum handelt. Ist dies der Fall, liegen ein optimierter Flugzeugentwurf bzw. mehrere optimierte Flugzeugentwürfe vor. Sofern ein Optimum noch nicht erreicht ist, wird der Anforderungskatalog verändert und das beschriebene Verfahren wird solange iterativ durchlaufen, bis ein Optimum erreicht wird.

Da es sich bei dem erfindungsgemäßen Verfahren um ein iteratives Verfahren handelt, wird beim ersten Durchlauf eine Überprüfung, ob ein Optimum vorliegt, in der Regeln nicht möglich sein. In diesem Fall fällt die Überprüfung auf ein Optimum negativ aus und die einzelnen erfindungsgemäßen Verfahrensschritte werden entsprechend mit verändertem Anforderungskatalog solange iteriert, bis die Überprüfung auf ein Optimum tatsächlich durchgeführt werden kann und das vorliegen eines Optimums ergibt. Dabei ist es grundsätzlich möglich, dass sich eine Gesamtflugnetzeffizienz als Optimum herausstellt, welche während der ersten Iterationsschritte ermittelt wurde, aber zum Zeitpunkt dessen Ermittlung nicht als solches identifiziert werden konnte.

Es kann auch eine Mindestanzahl von Iterationsschritten vorgegeben sein, wobei die Iterationsschritte jeweils mit verändertem Anforderungskatalog durchgeführt werden. Liegt eine der Anzahl der Mindestiterationen entsprechende Anzahl an Gesamtflugnetzeffizienzen basierend auf unterschiedlichen Anforderungskatalogen vor, ist eine Überprüfung, ob eine weitere, gemäß dem erfindungsgemäßen Verfahren berechnete Gesamtflugnetzeffizienz ein Optimum darstellt, grundsätzlich möglich. Auch hier wird jedoch solange iteriert, bis ein tatsächliches Optimum gefunden wurde.

Je nach Aufgabenstellung kann das erfindungsgemäße Verfahren ein lokales oder absolutes Optimum in der Gesamtflugnetzeffizienz ermitteln. Ein lokales Optimum kann bspw. dann erwünscht sein, wenn ein bestimmtes bereits vorhandenes Flugzeugmodell ersetzt werden und eine begrenzte Anzahl erfindungsgemäß optimierter Flugzeugentwürfe die dadurch entstehende Lücke schließen soll. Ein absolutes Optimum kann insbesondere dann erwünscht sein, wenn eine Vielzahl unterschiedlicher erfindungsgemäß optimierter Flugzeugentwürfe ein möglichst breites Spektrum an Anforderungen abdecken soll.

Neben dem wenigstens einen optimierten Flugzeugentwurf kann als weiteres Ergebnis des Verfahrens das Ergebnis der Simulation des Gesamtflugnetzes gesehen werden. Aus dem Ergebnis der Simulation kann abgelesen werden, welcher Flugzeugentwurf auf welcher Flugstrecke des Gesamtflugnetzes zum Einsatz kommen sollte, um eine optimale Gesamtflugnetzeffizienz zu erreichen.

Anders als im Stand der Technik wird bei dem erfindungsgemäßen Verfahren also ein Flugzeugentwurf nicht lediglich auf einen vorgegebenen Auslegungspunkt hin optimiert, sondern es wird vielmehr auch dieser Auslegungspunkt in Form eines veränderlichen Anforderungskataloges optimiert. Im Ergebnis erhält man einen oder mehrere Flugzeugentwürfe, die so auf ein vorgegebenes Gesamtflugnetz abgestimmt sind, dass eine optimale Gesamtflugnetzeffizienz erreicht werden kann.

Bei der Anpassung des Anforderungskatalogs ist es möglich, dass sich die Anzahl der Flugzeugentwürfe, für die Anforderungen im Anforderungskatalog enthalten sind, ändert. So kann in dem erfindungsgemäßen Verfahren bspw. ermittelt werden, dass sich die Gesamtflugnetzeffizienz steigern lässt, wenn anstelle eines einzelnen neuen Flugzeugentwurfes trotz der dadurch erhöhten Entwicklungskosten zwei neue Flugzeugentwürfe vorgesehen werden, wobei der eine der beiden Flugzeugentwürfe für einen ersten Teil der Strecken des Gesamtflugnetzes optimiert ist, während der andere Flugzeugentwurf für einen zweiten Teil der Strecken des Gesamtflugnetzes optimiert ist.

Im erfindungsgemäßen Verfahren können auch Randbedingungen hinsichtlich der maximalen Anzahl der möglichen Flugzeugentwürfe vorgegeben sein. So ist es bspw. möglich, die Anzahl der neuen Flugzeugentwürfe oder die Höhe der summierten Entwicklungskosten für alle neuen Flugzeugentwürfe zu beschränken. Dadurch können die Entwicklungskapazitäten von Flugzeugherstellern berücksichtigt werden.

Insbesondere in den Fällen, in denen die Anzahl der neuen Flugzeugentwürfe beschränkt ist, aber auch in allen anderen Fällen ist es bevorzugt, wenn bei der Simulation des Gesamtflugnetzes neben den Flugzeugentwürfen auf Basis des Anforderungskataloges auch bereits verfügbare Flugzeugmodelle berücksichtigt werden. Dabei können alle bereits verfügbaren Flugzeugmodelle oder nur eine Auswahl davon berücksichtigt werden. Die Simulation des Gesamtflugnetzes bleibt dann also nicht mehr auf die neuen Flugzeugentwürfe, die mit dem Syntheseverfahren gemäß dem Anforderungskatalog ermittelt werden, beschränkt, sondern berücksichtigt auch Flugzeugmodelle, die bereits am Markt verfügbar sind. Dadurch ist es in der Regel möglich, alle Flugstrecken eines Flugnetzes zu bedienen und den oder die neuen Flugzeugentwürfe optimal auf einen Teil der Strecken im Flugnetz anzupassen, sodass unter Berücksichtigung bereits verfügbarer Flugzeugmodelle ein Optimum der Gesamtflugnetzeffizienz erreicht wird.

Soll durch das erfindungsgemäße Verfahren in erster Linie ein bestimmtes bereits verfügbares Flugzeugmodell durch einen neuen Flugzeugentwurf ersetzt werden, so kann die Simulation während des Verfahrens mit dem Flugzeugentwurf der übrigen verfügbaren Flugzeugmodelle durchgeführt werden. Das bestimmte verfügbare Flugzeugmodell ist dann vorzugsweise von der Simulation ausgenommen und der Flugzeugentwurf wird derart optimiert, dass er das bestimmte verfügbare Flugzeugmodell möglichst optimal ersetzt. Der initiale Anforderungskatalog für den neuen Flugzeugentwurf kann sich dabei an den technischen Eigenschaften des bestimmten Flugzeugmodells orientieren, wird aber im Laufe des erfindungsgemäßen Verfahrens wie beschrieben optimiert.

Das erfindungsgemäße Verfahren unter Berücksichtigung bereits bekannter Flugzeugmodelle in der Simulation wird anhand eines Beispiels deutlich. Ist bspw. ein Langstreckenflugzeug verfügbar und wird dieses bei der Simulation berücksichtigt, so wird das erfindungsgemäße Verfahren bei einem Gesamtflugnetz umfassend Lang- und Kurzstrecken und der Vorgabe, nur einen einzelnen Flugzeugentwurf zu optimieren, eher zu einem Flugzeugentwurf führen, welcher auf die Kurzstrecken angepasst ist. Dabei wird das erfindungsgemäße Verfahren selbstständig ermitteln, welche Strecken mit welchen Flugzeugen zu bedienen sind, um eine optimale Gesamtflugnetzeffizienz zu erreichen. So ist es bspw. denkbar, dass die Gesamtflugnetzeffizienz maximal ist, wenn der Großteil der Kurzstrecken durch den neuen Flugzeugentwurf abgedeckt wird, ein kleiner Teil der Kurzstreckenverbindungen mit besonderen Start- und Landevoraussetzungen aber trotz allem durch das bereits verfügbare Langstreckenflugzeug bedient wird. Das erfindungsgemäße Verfahren berücksichtigt nämlich, dass sofern der neue Flugzeugentwurf auch für den genannten kleinen Teil der Kurzstrecken geeignet sein sollte, die Betriebskosten des Flugzeugentwurfes grundsätzlich derart steigen würden, dass die Effizienz auf den übrigen Kurzstrecken sinkt. In der Summe könnte so die Gesamtflugnetzeffizienz nicht mehr maximal sein. Anders als bei den Entwicklungsverfahren gemäß dem Stand der Technik kann das erfindungsgemäße Verfahren in dem genannten Beispiel also zu einem Flugzeugentwurf für ein Kurzstreckenflugzeug führen, der zwar nicht alle Kurzstrecken des Gesamtflugnetzes bedienen kann, dies jedoch auch bei Bedienung bestimmter Kurzstrecken durch das bereits vorhandene Langstreckenflugzeug in der Summe vorteilhaft ist.

Zusammenfassend ist festzuhalten, dass sich das erfindungsgemäße Verfahren dadurch auszeichnet, dass ausgehend von einem Anforderungskatalog mit technischen Anforderungen für einen oder mehrere Flugzeugentwürfe unter Berücksichtigung aus der technischen Konfiguration eines oder mehrerer Flugzeugentwürfe ableitbarer Größen und eines Gesamtflugnetzes iterativ ein oder mehrere optimierte Flugzeugentwürfe ermittelt werden. Die so ermittelten Flugzeugentwürfe zeichnen sich durch eine an das Gesamtflugnetz optimierte Konfiguration aus, wodurch sich einerseits die Gesamtflugnetzeffizienz steigern lässt, andererseits aber bspw. auch der Gesamttreibstoffverbrauch der auf dem Gesamtflugnetz eingesetzten Flugzeuge reduzieren lässt, da die für die einzelnen Flugstrecken vorgesehenen Flugzeuge an diese Flugstrecken möglichst optimal angepasst sind.

Das erfindungsgemäße System ist zur Durchführung des erfindungsgemäßen Verfahrens ausgebildet. Zur Erläuterung des Systems wird daher auf die vorstehenden Ausführungen verwiesen.

Es ist bevorzugt, eine mit dem Simulationsmodul verbundene erste Datenbank vorzusehen, die Informationen zu allen Flugstrecken des Gesamtflugnetzes umfasst. Die durch das Simulationsmodul durchzuführende Simulation kann dann auf Basis der Daten aus der ersten Datenbank erfolgen.

Es ist weiter bevorzugt, eine mit dem Simulationsmodul verbundene zweite Datenbank vorzusehen, die Informationen zu verfügbaren Flugzeugmodellen umfasst. Das Simulationsmodul ist dann bevorzugt zur Berücksichtigung dieser Informationen bei der Durchführung der Simulation des Gesamtflugnetzes ausgebildet.

Das System kann weiter vorzugsweise zur Durchführung des erfindungsgemäßen Verfahrens und der vorteilhaften Weiterbildungen des Verfahrens ausgebildet sein. Zur Erläuterung dieser Weiterbildungen wird auf die vorstehenden Ausführungen verwiesen.

Die Erfindung wird nun anhand eines Ausführungsbeispiels unter Bezugnahme auf die beigefügten Zeichnungen näher beschrieben. Es zeigen:
- Figur 1:: ein erfindungsgemäßes System, welches zur Durchführung des erfindungsgemäßen Verfahrens ausgebildet ist; und
- Figur 2:: ein Ablaufdiagramm des erfindungsgemäßen Verfahrens, wie es auf dem System gemäß Figur 1 abläuft.

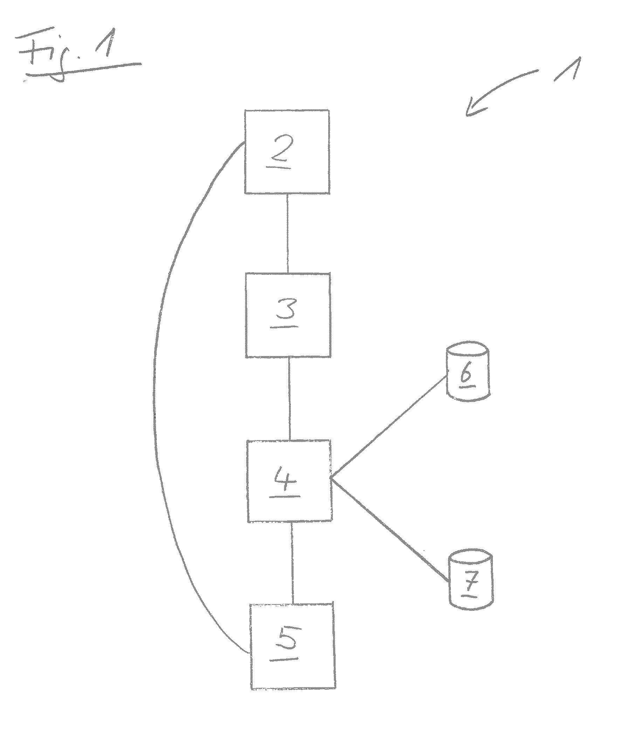

In Figur 1 ist ein erfindungsgemäßes System 1 dargestellt, welches zur Durchführung des erfindungsgemäßen Verfahrens ausgebildet ist. Das System 1 umfasst einen Anforderungskatalogspeicher 2, ein Synthesemodul 3, ein Simulationsmodul 4 sowie ein Optimierungsmodul 5. Die genannten Komponenten sind in Reihe miteinander verbunden. Das Optimierungsmodul 5 ist darüber hinaus auch mit dem Anforderungskatalogspeicher 2 verbunden.

Weiterhin vorgesehen sind eine erste Datenbank 6 und eine zweite Datenbank 7, die jeweils mit dem Simulationsmodul 4 verbunden sind. In der ersten Datenbank 6 ist ein Gesamtflugnetz abgebildet, d. h., in der Datenbank 6 sind Informationen zu allen Flugstrecken des Gesamtflugnetzes hinterlegt. In der zweiten Datenbank 7 sind Informationen über alle oder einen Teil der am Markt verfügbaren Flugzeuge hinterlegt.

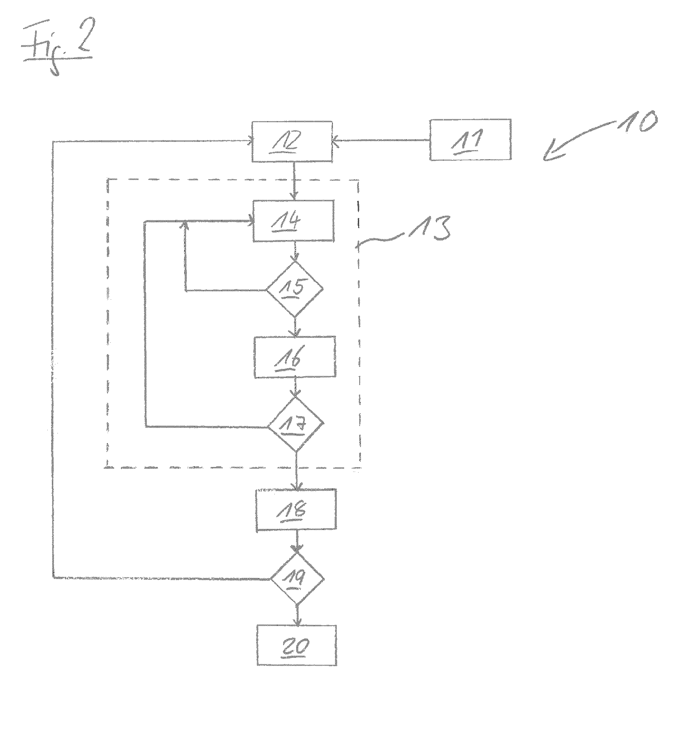

Im Anforderungskatalogspeicher 2 ist ein Anforderungskatalog umfassend technische Anforderungen für einen neuen Flugzeugentwurf hinterlegt. Diese technischen Anforderungen können die minimale Nutzlastmasse, die minimale Reichweite sowie Start- und Landeanforderungen für einen oder mehrere Flugzeugentwürfe umfassen. Zusätzlich können noch Anforderungen hinsichtlich der Reiseflughöhe und/oder der Reisegeschwindigkeit, sowie Maximalwerte für Spannweite, Rumpflänge und/oder Flächenpressung pro Fahrwerksrad enthalten sein. Zu Beginn ist der Anforderungskatalog manuell vorgegeben, wird aber, wie nachfolgend erläutert, durch das erfindungsgemäße Verfahren 10 (vgl. Figur 2) iterativ verändert.

Der Anforderungskatalog aus dem Anforderungskatalogspeicher 2 wird dem Synthesemodul 3 zugeführt, welches auf Basis der technischen Anforderungen ein Syntheseverfahren zur Optimierung eines oder mehrerer Flugzeugentwürfe entsprechend den technischen Anforderungen durchführt. Ergebnis dieses Syntheseverfahrens sind ein oder mehrere Flugzeugentwürfe, die auf dem Anforderungskatalog basieren und möglichst optimale, d. h. geringe Betriebskosten aufweisen. Diese ein oder mehreren iterativ ermittelten Flugzeugentwürfe werden an das Simulationsmodul 4 übermittelt.

Das Simulationsmodul 4 ist zur Durchführung einer Simulation des in der ersten Datenbank 6 abgebildeten Gesamtflugnetzes ausgebildet. Dazu berechnet das Simulationsmodul 4 für jede Flugstrecke des Gesamtflugnetzes eine Flugstreckeneffizienz, wobei die potenzielle Effizienz auf einer Flugstrecke für alle verfügbaren, vom Synthesemodul 3 übermittelten Flugzeugentwürfe sowie der in der zweiten Datenbank 7 hinterlegten verfügbaren Flugzeugmodelle berechnet wird, die hinsichtlich ihrer technischen Voraussetzungen grundsätzlich geeignet sind, die Flugstrecke zu bedienen. Als letztendliche Flugstreckeneffizienz wird dann diejenige potenzielle Effizienz gewählt, die zum höchsten Gesamtflugnetzeffizienzwert bei diesem Simulationsschritt beisteuert.

Anschließend wird durch das Simulationsmodul 4 die Gesamtflugnetzeffizienz als Summe der einzelnen Flugstreckeneffizienzen gebildet und an das Optimierungsmodul 5 übermittelt.

Das Optimierungsmodul 5 überprüft, ob es sich bei der Gesamtflugnetzeffizienz um ein Optimum handelt. Ist dies der Fall, werden der oder die durch das Synthesemodul 3 ermittelten Flugzeugentwürfe als optimierte Flugzeugentwürfe ausgegeben. Liegt kein Optimum der Gesamtflugnetzeffizienz vor, wird der Anforderungskatalog im Anforderungskatalogspeicher 2 durch das Optimierungsmodul 5 verändert und das Verfahren wird solange iterativ wiederholt, bis eine optimale Gesamtflugnetzeffizienz vorliegt.

Das durch das System 1 gemäß Figur 1 durchgeführte Verfahren wird nunmehr anhand des Ablaufdiagramms aus Figur 2 näher erläutert. Aus den nachfolgenden Ausführungen ergeben sich auch Einzelheiten, wie die einzelnen Komponenten des Systems 1 gemäß Figur 1 ausgebildet sein können.

Zu Beginn des erfindungsgemäßen Verfahrens 10 wird ein initialer Anforderungskatalog festgelegt. Diese Festlegung kann durch manuelle Eingabe (Schritt 11) erfolgen. In diesem Anforderungskatalog sind technische Anforderungen für einen oder mehrere Flugzeugentwürfe enthalten. Zu den technischen Anforderungen zählen minimale Nutzlastmasse, minimale Reichweite sowie Start- und Landeanforderungen. Zusätzlich können noch Anforderungen hinsichtlich der Reiseflughöhe und/oder der Reisegeschwindigkeit enthalten sein. Der Anforderungskatalog kann auf einen einzelnen Flugzeugentwurf gerichtet sein, also lediglich einen Satz an technischen Anforderungen enthalten. Es ist aber auch möglich, dass der Anforderungskatalog Anforderungen für mehrere Flugzeugentwürfe enthält, wobei dann eine der Anzahl der Flugzeugentwürfe entsprechenden Anzahl an Sätzen technischer Anforderungen enthalten sind.

Der initiale Anforderungskatalog wird derart abgespeichert, dass er, wie später erläutert, während des erfindungsgemäßen Verfahrens geändert werden kann (Schritt 12).

Auf Basis des Anforderungskatalogs wird zunächst ein aus dem Stand der Technik bekanntes Syntheseverfahren 13 durchgeführt. Bei dem Syntheseverfahren 13 wird für jeden, im Anforderungskatalog angelegten Flugzeugentwurf ein hinsichtlich der zu erwartenden Kosten, insbesondere der zu erwartenden Betriebskosten optimierter Flugzeugentwurf ermittelt.

Bei dem Syntheseverfahren 13 wird zunächst eine initiale Rumpfdimensionierung sowie eine initiale Antriebs-, Tragflächen- und Leitwerksdimensionierung für einen Flugzeugentwurf durchgeführt. Basierend auf diesen Größen lässt sich dann eine Massenabschätzung durchführen sowie die Auftriebsverteilung der Tragflächen und der Schwerpunkt bestimmen, der Widerstand des Flugzeugentwurfs abschätzen und nicht zuletzt die Flugleistungen des Flugzeugentwurfs mit der angenommenen Dimensionierung bestimmen (Schritt 14).

Es wird dann überprüft, ob das Höchstabfluggewicht des Flugzeugentwurfes konvergiert und die technischen Anforderungen aus dem Anforderungskatalog für diesen Flugzeugentwurf, insbesondere Reichweiten-, Start- und Landeanforderungen sowie ggf. Reiseflughöhe, Reisefluggeschwindigkeit und/oder Flächenpressung pro Fahrwerksrad, erfüllt sind (Schritt 15). Ist dies nicht der Fall, werden die Rumpfdimensionierung sowie die Antriebs-, Tragflächen- und Leitwerksdimensionierung verändert und Schritt 14 erneut durchgeführt. Es kommt so zu einem iterativen Prozess, der solange durchgeführt wird, bis das Höchstabfluggewicht des Flugzeugentwurfes konvergiert und die technischen Anforderungen aus dem Anforderungskatalog für diesen Flugzeugentwurf erfüllt sind.

Ist die entsprechende Überprüfung in Schritt 15 positiv, werden in einem nächsten Schritt die zu erwartenden Kosten für den Flugzeugentwurf berechnet (Schritt 16). Die Betriebskosten lassen sich dabei in Abhängigkeit von technischen Größen bzw. der Konfiguration des Flugzeugentwurfes bestimmen. So lassen sich bspw. der Treibstoffverbrauch und die damit verbunden Kosten aus dem Schub-Masse-Verhältnis des Flugzeugentwurfs berechnen, die Wartungskosten lassen sich in Abhängigkeit der Flugzeugmasse sowie der Anzahl der Triebwerke ermitteln, Flughafensteuern sind abhängig von der Flugzeugmasse, etc.

In Schritt 17 wird dann überprüft, ob ein Optimum hinsichtlich der in Schritt 16 berechneten Kosten erreicht ist. Ist dies nicht der Fall, werden erneut die Rumpfdimensionierung sowie die Antriebs-, Tragflächen- und Leitwerksdimensionierung verändert und es wird mit Schritt 14 fortgefahren. Dies wird solange wiederholt, bis ein Kostenoptimum erreicht ist. Ist dies der Fall, wird der durch dieses iterative Verfahren ermittelte Flugzeugentwurf dem nachfolgenden Schritt 18 zugeführt.

Das Syntheseverfahren 13 wird für jeden Flugzeugentwurf, für den technische Anforderungen im Anforderungskatalog vorhanden sind, gesondert durchgeführt, sodass bei technischen Anforderungen für mehr als einen Flugzeugentwurf auch entsprechend mehrere Flugzeugentwürfe dem Schritt 18 zugeführt werden.

Im Schritt 18 wird eine Simulation des Gesamtflugnetzes durchgeführt. Dazu wird für jede Strecke des Gesamtflugnetzes jeweils eine Flugstreckeneffizienz ermittelt. Dazu werden die für eine Flugstrecke mit einem bestimmten Flugzeugentwurf oder einem bereits verfügbaren Flugzeugmodell, wie es bspw. in der ersten Datenbank 6 (vgl. Figur 1) abgespeichert sein kann, zu erwartende Einkünfte und Betriebskosten miteinander verrechnet. Neben den eigentlichen Betriebskosten können auch die Entwicklungskosten eines neuen Flugzeugs anteilig in die Berechnung der Flugstreckeneffizienz einfließen. Ist mehr als ein Flugzeugentwurf bzw. verfügbares Flugzeug aus technischer Sicht geeignet, eine bestimmte Flugstrecke des Gesamtflugnetzes zu bedienen, so wird für jeden Flugzeugentwurf bzw. jedes verfügbare Flugzeug die potenzielle Effizienz auf der Flugstrecke berechnet. Als letztendliche Flugstreckeneffizienz für eine bestimmte Strecke wird diejenige potenzielle Effizienz auf dieser Flugstrecke ausgewählt, die zum höchsten Gesamtflugnetzeffizienzwert bei diesem Simulationsschritt beisteuert. Bei der Auswahl der Flugzeugentwürfe oder der verfügbaren Flugzeuge für die einzelnen Flugstrecken im Gesamtflugnetz können auch Randbedingungen, wie die maximale Anzahl unterschiedlicher Flugzeugtypen im Gesamtnetz oder die Mindestanzahl von Flugzeugen eines bestimmten Flugzeugtyps, berücksichtigt werden. Anschließend werden die einzelnen Flugstreckeneffizienzen zur Gesamtflugnetzeffizienz aufsummiert.

In Schritt 19 wird überprüft, ob ein Optimum hinsichtlich der Gesamtflugnetzeffizienz vorliegt. Ist dies nicht der Fall, wird der Anforderungskatalog verändert und das Verfahren 10 beginnt bei Schritt 12 erneut. Der Anforderungskatalog wird dabei solange iteriert, bis ein Optimum der Gesamtflugnetzeffizienz vorliegt. Dabei kann der Anforderungskatalog auch soweit verändert werden, dass sich die Anzahl der letztendlichen Flugzeugentwürfe verändert.

Ist ein Optimum der Gesamtflugnetzeffizienz erreicht, endet das Verfahren 10 dann mit Schritt 20, in dem dann ein oder mehrere optimierte Flugzeugentwürfe vorliegen. Zusätzlich zu dem wenigstens einen Flugzeugentwurf liegt außerdem noch das Ergebnis der Simulation aus Schritt 18 vor, aus dem hervorgeht, welche Flugstrecken im untersuchten Gesamtflugnetz von dem wenigstens einen Flugzeugentwurf oder anderen verfügbaren Flugzeugen bedient werden sollten, um eine optimale Gesamtflugnetzeffizienz zu erreichen.

Die Erfindung wird nun anhand eines zahlenmäßigen Beispiels noch weiter verdeutlicht. In diesem Beispiel soll eine Flugzeugfamilie umfassend zwei für die Langstrecke geeignete Flugzeuge entworfen werden.

Im Anforderungskatalog sind dabei initial zwei Sätze an technischen Anforderungen vorgegeben, die jeweils die Anforderungen an einen Flugzeugentwurf abbilden. Für den ersten Flugzeugentwurf lauten die initialen Anforderungen hinsichtlich der Nutzlastmasse 60 t bei einer minimalen Reichweite von 6.750 NM, während der zweite Flugzeugentwurf initial eine Nutzlastmasse von 50 t bei einer minimalen Reichweite von 7.750 NM aufweisen soll. Die initialen Start- und Landeanforderungen sind für beide Flugzeugentwürfe auf den ungünstigsten Flughafen des Gesamtflugnetzes abgestimmt, d. h., gemäß den initialen Anforderungen sollen beide Flugzeugentwürfe auf diesem Flughafen mit einer Landebahnlänge von 3.000m bei einer Flugplatzbezugstemperatur von 30 °C und einer Höhe von 2.500m über dem Meeresspiegel (Normalnull) starten und landen können. Die initialen Anforderungen für die beiden Flugzeugentwürfe gemäß Anforderungskatalog sind in der nachfolgenden Tabelle zusammengefasst:

| | Nutzlast | Reichweite | Start-/Landebedingungen |
|---|---|---|---|
| A | 60 t | 6.750 NM | 3.000m bei 30 °C in 2.500m ü. NN |
| B | 50 t | 7.750 NM | 3.000m bei 30 °C in 2.500m ü. NN |

Um die Entwicklungskosten für die Flugzeugfamilie zu begrenzen, ist weiterhin festgelegt, dass beide zu ermittelnden Flugzeugentwürfe mit identischen Tragflächen und identischen Triebwerken ausgerüstet werden sollen. Außerdem ist festgelegt, dass das Ergebnis des erfindungsgemäßen Verfahrens auf maximal zwei Flugzeugentwürfe beschränkt bleiben soll.

In einem ersten Schritt wird in einem Syntheseverfahren für die beiden Flugzeugentwürfe jeweils hinsichtlich ihrer Betriebskosten die optimale Konfiguration ermittelt. Dazu werden die verschiedenen Entwurfsgrößen wie Rumpflänge sowie Antriebs-, Tragflächen- und Leitwerksdimensionierung variiert, bis jeweils das Höchstabfluggewicht konvergiert, bei Einhaltung der sonstigen Randbedingungen, wie Reichweiten-, Start- und Landeanforderung des jeweiligen Flugzeugentwurfes. Das Höchstabfluggewicht und die Reichweiten- bzw. Start- und Landeeigenschaften eines Flugzeugentwurfes lassen sich aus den Entwurfsgrößen und daraus resultierenden Zwischengrößen, wie Auftriebsverteilung des Flügels, Masse, Schwerpunkt, Widerstand und Flugleistungen ermitteln. Dabei ist zu beachten, dass gemäß Vorgabe bei dem vorliegenden Beispiel die Antriebs-, Tragflächen- und Leitwerksdimensionierung bei beiden Flugzeugentwürfen gleich sein soll.

Anschließend wird für jeden Entwurf eine Betriebskostenabschätzung durchgeführt und das vorbeschriebene iterative Verfahren solange wiederholt, bis ein Betriebskostenoptimum vorliegt. Die zu erwartenden Betriebskosten lassen sich jeweils auf Basis der technischen Größen der Flugzeugentwürfe, wie oben erläutert, ermitteln.

Als Ergebnis des Syntheseverfahrens ergeben sich zwei Flugzeugentwürfe, die identische Tragflügel, Leitwerke und Triebwerke aufweisen, sich aber in der Rumpflänge unterscheiden.

Anschließend wird eine Simulation des Gesamtflugnetzes durchgeführt. In diesem Beispiel soll das Gesamtflugnetz insgesamt fünf Flugstrecken umfassen:

| | Länge | Nutzlastaufkommen/Tag | Flughafenslots/Tag |
|---|---|---|---|
| 1 | 5.500 NM | 55 t | 2 |
| 2 | 4.500 NM | 130 t | 3 |
| 3 | 7.000 NM | 40 t | 2 |
| 4* | 5.000 NM | 40 t | 1 |
| 5 | 1.200 NM | 120 t | 6 |

Die mit "*" markierte Strecke umfasst den "ungünstigsten" Flughafen des Gesamtflugnetzes mit einer Landebahnlänge von 3.000m bei einer Flugplatzbezugstemperatur von 30 °C und einer Höhe von 2.500m über dem Meeresspiegel. Die übrigen Strecken weisen jeweils Start- und Landebedingungen vergleichbar zu einer Landebahnlänge von 2.500m bei Standardbedingungen auf.

Neben den beiden Flugzeugentwürfen A und B wird außerdem noch ein bekanntes und am Markt verfügbares Flugzeugmodell C in der Simulation berücksichtigt. Bei dem Flugzeugmodell C handelt es sich um ein Kurzstreckenflugzeug mit den folgenden Eigenschaften:

| | Nutzlast | Reichweite | Start-/Landebedingungen |
|---|---|---|---|
| C | 20 t | 1.500 NM | 1.600m bei Standardbedingungen |

In der Simulation des Gesamtflugnetzes wird nun die Flugstreckeneffizienz für jede einzelne Flugstrecke berechnet, wobei zunächst jeweils die potenzielle Effizienz auf einer Strecke für jeden Flugzeugentwurf bzw. jedes verfügbare Flugzeugmodell berechnet wird, welches grundsätzlich auf einer Flugstrecke zum Einsatz kommen kann. So können auf den Flugstrecken 1, 2 und 4 grundsätzlich die Flugzeugentwürfe A und B zum Einsatz kommen, während auf der Flugstrecke 3 nur der Flugzeugentwurf B zum Einsatz kommen kann, da Flugzeugentwurf A nicht die notwendige maximale Reichweite aufweist. Auf der Flugstrecke 5 können die Flugzeugentwürfe A und B sowie das bereits verfügbare Flugzeugmodell C eingesetzt werden.

Bei der Simulation wird ermittelt, mit welchem Flugzeugentwurf bzw. Flugzeugmodell auf einer Flugstrecke die größte Effizienz erzielt werden kann. Dazu werden für jede Strecke die zu erwartenden Erlöse sowie die anfallenden Betriebskosten ermittelt und miteinander verrechnet. Aus der Summe der einzelnen Flugstreckeneffizienzen ergibt sich dann ein Gesamtflugnetzeffizienz X.

Bei der Simulation des Gesamtflugnetzes auf Basis der Flugzeugentwürfe A und B sowie dem verfügbaren Flugzeugmodell C kann sich bspw. die folgende Aufteilung ergeben:

| Strecke | Flugzeugentwurf/-modell | Anzahl Flüge/Tag |
|---|---|---|
| 1 | A | 1 |
| 2 | A | 3 |
| 3 | B | 1 |
| 4 | B | 1 |
| 5 | C | 6 |

Da zu diesem Zeitpunkt nicht festgestellt werden kann, ob es sich bei der Gesamtflugnetzeffizienz X um ein Optimum handelt, werden die zuvor beschriebenen Verfahrensschritte erneut durchgeführt, wobei jedoch der Anforderungskatalog für die Flugzeugentwürfe verändert wird. Die geänderten Anforderungen für die beiden Flugzeugentwürfe gemäß Anforderungskatalog lauten:

| | Nutzlast | Reichweite | Start-/Landebedingungen |
|---|---|---|---|
| A' | 65 t | 5.500 NM | 2.500m bei Standardbedingungen |
| B' | 40 t | 7.000 NM | 3.000m bei 30 °C in 2.500m ü. NN |

Auf Basis des geänderten Anforderungskatalogs für die Flugzeugentwürfe A' und B' werden zunächst betriebskostenoptimierte Flugzeugentwürfe mithilfe des Syntheseverfahrens ermittelt, die dann zusammen mit dem bereits bekannten Flugzeugmodell C der Simulation des Gesamtflugnetzes zugeführt werden.

Bei der Simulation des Gesamtflugnetzes auf Basis der Flugzeugentwürfe A' und B' sowie dem verfügbaren Flugzeugmodell C kann sich bspw. die folgende Aufteilung ergeben:

| Strecke | Flugzeugentwurf/-modell | Anzahl Flüge/Tag |
|---|---|---|
| 1 | A | 1 |
| 2 | A | 2 |
| 3 | B | 1 |
| 4 | B | 1 |
| 5 | C | 6 |

Die sich bei dieser Simulation ergebende Gesamtflugnetzeffizienz X' ist höher als diejenige Gesamtflugnetzeffizienz X aus der vorherigen Simulation. Dies ist begründet in der Tatsache, dass nunmehr der Flugzeugentwurf A' gut auf die Strecken 1 und 2 abgestimmt ist und bspw. keine besonderen Start- und Landebedingungen mehr erfüllen muss, während der Flugzeugentwurf B' auf die Bedingungen der Strecken 3 und 4 abgestimmt ist. Das bereits verfügbare (Kurzstrecken-)Flugmodell C ist weiterhin gut geeignet, die Kurzstrecke 5 zu bedienen.

Die genannten Schritte können so häufig wiederholt werden, bis das Optimum der Gesamtflugnetzeffizienz erreicht ist. Im dargestellten Ausführungsbeispiel soll davon ausgegangen werden, dass es sich bei den Flugzeugentwürfen A' und B' um die angesichts des zu untersuchenden Gesamtflugnetzes optimalen Flugzeugentwürfe handelt. Neben den Informationen über die optimalen Flugzeugentwürfe A' und B' bietet das erfindungsgemäße Verfahren noch zusätzlich die Informationen, auf welchen Flugstrecken welcher Flugzeugentwurf bzw. welches bereits verfügbare Flugzeugmodell eingesetzt werden soll, um das Optimum der Gesamtflugnetzeffizienz zu erreichen.

Selbstverständlich ist es möglich, das nur an einem Beispiel dargestellte erfindungsgemäße Verfahren zu verfeinern. So kann bspw. anstelle des Nutzlastaufkommens pro Tag ein jahreszeitlicher Verlauf eines Passagieraufkommens der Simulation zugrunde gelegt werden, wobei das Passagieraufkommen vorzugsweise in Normaltarifpassagiere und Sondertarifpassagiere aufgeschlüsselt wird, um die zu erwartenden Effizienz auf einer Flugstrecke besser abschätzen zu können. Auch ist es selbstverständlich möglich, mehr Flugstrecken und/oder Flugzeugentwürfe bzw. -modelle bei der Simulation zu berücksichtigen. Auch lassen sich komplexe Zusammenhänge zwischen einzelnen Flugstrecken, bspw. als Flugstrecken mit Zwischenstopp, abbilden. Auch kann über die Simulation ermittelt werden, wie viele Maschinen eines Flugzeugentwurfs bzw. Flugzeugmodells erforderlich sind, um das untersuchte Gesamtflugnetz zu bedienen.

Bei dem untersuchten Gesamtflugnetz kann es sich um ein tatsächliches, derzeitiges Flugnetz einer oder mehrere Fluggesellschaften handeln. Es ist aber auch möglich, ausgehend von einem tatsächlichen Gesamtflugnetz ein zukünftiges Gesamtflugnetz zu projizieren, welches bspw. das erwartete Gesamtflugnetz in 10 oder 20 Jahren darstellt. Dies bietet den Vorteil, dass der durch das erfindungsgemäße Verfahren ermittelte wenigstens eine Flugzeugentwurf an die Erfordernisse zum Ende seiner Entwicklungszeit angepasst ist.

## Patentansprüche

1. Verfahren (10) zum Entwerfen von Flugzeugen, umfassend die Schritte:
a. Festlegen eines initialen Anforderungskatalogs für wenigstens einen Flugzeugentwurf (Schritt 11);
b. Durchführen einer Optimierung des wenigstens einen Flugentwurfs auf Basis des Anforderungskatalogs hinsichtlich der zu erwartenden Betriebskosten (Schritt 13);
c. Simulation eines vorgegebenen Gesamtflugnetzes mit dem wenigstens einen Flugzeugentwurf und Ermittlung der Gesamtflugnetzeffizienz (Schritt 18);
d. Überprüfung, ob die ermittelte Gesamtflugnetzeffizienz ein Optimum darstellt (Schritt 19); wenn nicht:
e. Anpassung des Anforderungskatalogs (Schritte 19 und 12) und Iteration ab Schritt (b).

2. Verfahren nach Anspruch 1,
**dadurch gekennzeichnet, dass**
der Anforderungskatalog Anforderungen hinsichtlich der minimalen Nutzlastmasse, der minimalen Reichweite, Start- und Landeanforderungen, minimale Reiseflughöhe, minimale Reisefluggeschwindigkeit und/oder Maximalwerte für Spannweite, Rumpflänge und/oder Flächenpressung pro Rad des Fahrwerks für wenigstens einen Flugzeugentwurf umfasst.

3. Verfahren nach Anspruch 1 oder 2,
**dadurch gekennzeichnet, dass**
für die Simulation in Schritt (c) (Schritt 18) für jede Flugstrecke des Gesamtflugnetzes Informationen über die Länge der Flugstrecke und/oder für jeden Flughafen der einzelnen Flugstrecken Start- und Landebedingungen, Maximalwerte für Spannweite, Rumpflänge und/oder Flächenpressung pro Rad des Fahrwerks verfügbar sind.

4. Verfahren nach Anspruch 3,
**dadurch gekennzeichnet, dass**
für die Simulation in Schritt (c) (Schritt 18) für jede Flugstrecke des Gesamtflugnetzes Informationen über das Nutzlastaufkommen und/oder über Flughafenslots an den Flughäfen der Flugstrecken verfügbar sind.

5. Verfahren nach Anspruch 4,
**dadurch gekennzeichnet, dass**
das Nutzlastaufkommen in Normaltarifnutzlastaufkommen und Sondertarifnutzlastaufkommen aufgeschlüsselt ist.

6. Verfahren nach einem der vorhergehenden Ansprüche,
**dadurch gekennzeichnet, dass**
bei der Simulation in Schritt (c) (Schritt 18) bereits verfügbare Flugzeugmodelle berücksichtigt werden.

7. Verfahren nach einem der vorhergehenden Ansprüche,
**dadurch gekennzeichnet, dass**
die Anpassung des Anforderungskatalogs in Schritt (e) (Schritte 19 und 12) zu einer Änderung der Anzahl der Flugzeugentwürfe im Anforderungskatalog führt.

8. Verfahren nach einem der vorhergehenden Ansprüche,
**dadurch gekennzeichnet, dass**
Randbedingungen hinsichtlich der maximalen Anzahl der Flugzeugentwürfe und/oder der maximalen Entwicklungskosten für alle Flugzeugentwürfe vorgegeben sind.

9. Verfahren nach einem der vorhergehenden Ansprüche,
**dadurch gekennzeichnet, dass**
die Optimierung in Schritt (b) (Schritt 13) durch ein Syntheseverfahren erfolgt (Schritte 14 bis 17).

10. System (1) zum Entwerfen von Flugzeugen umfassend:
- einen Anforderungskatalogspeicher (2) zum Speichern eines Anforderungskatalogs für wenigstens einen Flugzeugentwurf;
- ein Synthesemodul (3) zur Ermittlung von hinsichtlich der Kosten optimierten Flugzeugentwürfen auf Basis des Anforderungskatalogs aus dem Anforderungskatalogspeicher (2);
- ein Simulationsmodul (4) zur Durchführung einer Simulation eines Gesamtflugnetzes mit den vom Synthesemodul (3) ermittelten Flugzeugentwürfen und zur Ermittlung der Gesamtflugnetzeffizienz; und
- ein Optimierungsmodul (5) zur Überprüfung, ob die vom Simulationsmodul (4) ermittelte Gesamtflugnetzeffizienz ein Optimum ist, und, sofern kein Optimum der Gesamtflugnetzeffizienz vorliegt, zur Veränderung des Anforderungskatalogs im Anforderungskatalogspeicher (2).

11. System nach Anspruch 10,
**dadurch gekennzeichnet, dass**
eine mit dem Simulationsmodul (4) verbundene erste Datenbank (6) vorgesehen ist, die Informationen zu allen Flugstrecken des Gesamtflugnetzes umfasst.

12. System nach Anspruch 10 oder 11,
**dadurch gekennzeichnet, dass**
eine mit dem Simulationsmodul (4) verbundene zweite Datenbank (7) vorgesehen ist, die Informationen zu verfügbaren Flugzeugmodellen umfasst und das Simulationsmodul (4) zur Berücksichtigung dieser Informationen bei der Durchführung der Simulation des Gesamtflugnetzes ausgebildet ist.

13. System nach einem der Ansprüche 10 bis 12,
**dadurch gekennzeichnet, dass**
das System zur Durchführung des Verfahrens nach einem der Ansprüche 1 bis 9 ausgebildet ist.
